(19) Europäisches Patentamt
European Patent Office
Office européen des brevets

(11) EP 4 582 501 A1

(12) EUROPEAN PATENT APPLICATION
published in accordance with Art. 153(4) EPC

(43) Date of publication:
**09.07.2025 Bulletin 2025/28**

(21) Application number: **23899975.9**

(22) Date of filing: **05.12.2023**

(51) International Patent Classification (IPC):
***C09D 11/30*** (2014.01) ***C08F 230/08*** (2006.01)
***C09D 11/101*** (2014.01) ***C07F 7/18*** (2006.01)
***C09D 11/38*** (2014.01)

(52) Cooperative Patent Classification (CPC):
**C07F 7/18; C08F 230/08; C09D 11/101; C09D 11/30; C09D 11/38; H10K 50/844;**
Y02E 10/549

(86) International application number:
**PCT/CN2023/136527**

(87) International publication number:
**WO 2024/120400 (13.06.2024 Gazette 2024/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **08.12.2022 CN 202211574896**

(71) Applicant: **Xi'an Smart Materials Co., Ltd.**
**Xi'an, Shaanxi 712099 (CN)**

(72) Inventors:
- **HE, Xin**
  **Shaanxi 712099 (CN)**
- **WANG, Na**
  **Shaanxi 712099 (CN)**
- **CHEN, Houyin**
  **Shaanxi 712099 (CN)**

(74) Representative: **Zacco GmbH**
**Bayerstrasse 83**
**80335 München (DE)**

# (54) PHOTOCURABLE INK COMPOSITION, AND PREPARATION METHOD THEREFOR AND USE THEREOF

(57) The present application belongs to the technical field of ink compositions. Provided are photocurable ink composition, and preparation method and application thereof. The photocurable ink composition includes a photocurable monofunctional silicon-containing monomer A, a photocurable bifunctional silicon-containing monomer B, a photocurable non-silicon monomer C, and a photoinitiator D. The photocurable ink composition has a high photocuring rate and plasma etching resistance, and the number of free small molecules is reduced, such that emission of impurity gases is reduced. Furthermore, an organic layer formed through curing has excellent flexibility, such that the bendability of an Organic Light-Emitting Diode is ensured.

EP 4 582 501 A1

## Description

This application is based upon and claims priority to Chinese Patent Application No. 202211574896.5 filed on December 08, 2022, the disclosure of which is hereby incorporated by reference in its entirety.

## Technical Field

The present disclosure belongs to the technical field of ink compositions, relates to preparation of an ink composition, and in particular, relates to photocurable ink composition, and preparation method and application thereof.

## Background

OLED (Organic light-emitting diode) is also referred to as Organic light-emitting diode, which is an important technology in the field of photoelectric display. Flexible OLEDs require a thin-film packaging technology to achieve their good bendability. The objective of OLED packaging is to separate a light-emitting device from an environment, so as to avoid invasion of adverse substances such as water and oxygen, thereby prolonging the service life of the OLEDs.

The thin film packaging is represented by a triple-stacked layer structure, and the excellent performance of the thin film packaging has become a mainstream mode of flexible OLED packaging. The triple-stacked layer is that the first inorganic layer (SiNx) is a smooth substrate, an organic layer is obtained by ink-jet printing and coating a photocurable ink composition on the substrate and then performing ultraviolet curing, and the third layer is the last inorganic layer (SiNx). Because of the characteristics of good photocuring properties, stability, mechanical properties, etc., the organic layer is considered as a conventional and effective packaging material. Furthermore, during the preparation of a packaging film, organic layer film-forming small molecules are highly susceptible to produce impurity gases, and data shows elevated outgas values. When there are more residual impurity gases in an organic film, during evaporation of an inorganic film, residual impurity gases at the organic layer are released, leading to a reduction in flatness of the inorganic film above, thus generating adverse effects on protected devices.

Disclosed in an existing Chinese patent I (Application No.: CN106257681B, date of publication: June 11, 2019) is an Organic light-emitting diode display device. In this patent, an organic layer prepared by using 10 wt%-70 wt% of (A) non-silicon dimethacrylate, 20 wt%-70 wt% of (B) silicon dimethacrylate, 5 wt%-40 wt% of (C) monomethacrylate, and 1 wt%-10 wt% of a (D) initiator has significant low water vapor permeability and oxygen permeability and excellent transmittance, but at the same time, it is difficult to meet the requirements of performance indexes required by the growing need for thin-film packaging, such as a high curing rate, a low outgas value, and excellent flexibility.

Provided in an existing Chinese patent II (Application No.: CN113717350A, date of publication: November 30, 2021) are a photocuring composition, a packaging structure, and a semiconductor device. In this patent, by using the photocuring composition prepared by, by mass part, 0.01-50 parts of a photocurable aromatic monomer, 0.01-90 parts of a photocurable reactive diluent, 0.01-10 parts of a free radical photoinitiator, 0.01-10 parts of a cationic photosensitizer, and 0-5 parts of an auxiliary agent, the problem of difficult improvement of photocuring efficiency, light transmittance, and a curing shrinkage rate at the same time in the related art is solved. However, from embodiments, the photocuring efficiency of this patent is relatively low, only reaching a maximum of 85.1%, which cannot meet the requirements of production.

## Summary

The present disclosure is intended to overcome the above disadvantages in the related art, and provides photocurable ink composition, and preparation method and application thereof, so as to solve the problems of low curing rates, poor flexibility, relatively-high outgas values, etc. of photocurable ink compositions.

In order to implement the above objectives, the present disclosure provides the following technical solutions.

In an aspect, the present disclosure provides a photocurable ink composition, including a photocurable monofunctional silicon-containing monomer A, a photocurable bifunctional silicon-containing monomer B, a photocurable non-silicon monomer C, and a photoinitiator D.

A structural formula of the photocurable monofunctional silicon-containing monomer A is shown in a Formula (1) below.

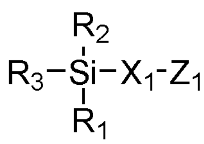

Formula (1)

$R_1$, $R_2$, and $R_3$ are each independently any one of alkyl, alkoxy, phenyl.
$X_1$ is a single bond, O, S, NH, or NR', wherein R' is any one of substituted or unsubstituted C1-C10 alkyl, substituted or unsubstituted C3-C10 cycloalkyl, and substituted or unsubstituted C1-C10 aryl.
$Z_1$ is a group shown in a Formula 2 or a Formula 3.

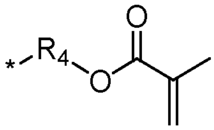 Formula (2) 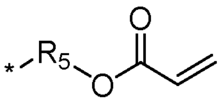 Formula (3)

In the Formulas (2) to (3), * is a binding site of $X_1$ in the Formula (1); and $R_4$ and $R_5$ are each independently any one of substituted or unsubstituted C1-C20 alkylene, and a substituted or unsubstituted C1-C20 alkylene oxygen group.
The term "substituted" means that at least one hydrogen atom in a functional group is substituted by a halogen (F, Cl, Br or I), a hydroxyl group, an imino group, a C1-C20 alkyl group, or a C6-C30 aryl group.
The term "alkyl" refers to a monovalent functional group of an alkane group; the alkane is saturated hydrocarbon; and the alkyl may be straight, branched, cyclic, or a combination thereof. The term "alkylene" refers to a divalent functional group of the alkane group; and the alkylene may be straight, branched, cyclic, or a combination thereof.
The term "alkylene oxygen group" may contain all functional groups in which one or more alkylene groups are bonded to at least one oxygen. For example, the alkylene oxygen group may contain $-(\text{alkylene-oxygen})_n$-alkylene-, $-(\text{alkylene-oxygen-alkylene})_n$-alkylene-, -alkylene-oxygen- or $-(\text{oxygen-alkylene})_n$-, where n is an integer from 1 to 10. The term "aralkyl" refers to a monovalent functional group of $-R^a-Ar^a$, where $R^a$ is alkylene, and $Ar^a$ is aryl.
The term "aryl" refers to a monovalent functional group that is aromatic and carbocyclic. The aryl may have one to five rings connected to or fused with an aromatic ring. Other ring structures may be aromatic, non-aromatic, or a combination thereof. An example of the aryl group includes, but is not limited to, phenyl, biphenyl, terphenyl, anthryl, naphthyl, acenaphthenyl, anthraquinonyl, phenanthryl, anthryl, pyrenyl, perylen group, and fluorenyl.
Further, a molecular weight of the photocurable monofunctional silicon-containing monomer is 250-350.
Further preferably, the photocurable monofunctional silicon-containing monomer (A) is shown in at least one of a chemical formula 1-1 or a chemical formula 1-2.

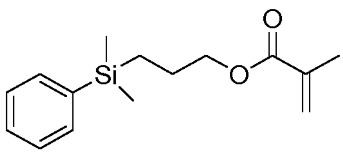

Formula 1-1

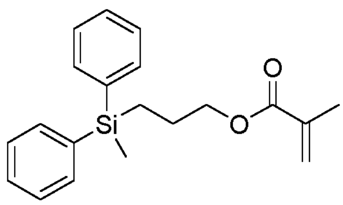

Formula 1-2.

Further, the photocurable bifunctional silicon-containing monomer (B) is shown in a Formula 4.

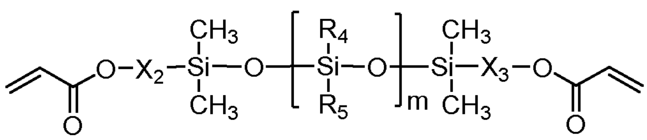

Formula 4

$R_4$ and $R_5$ are each independently any of alkyl and alkoxy; and $X_2$ and $X_3$ are each independently any of a single bond, alkylene, and an alkylene oxygen group.
Further, the photocurable non-silicon monomer (C) includes a fat ring or benzene-substituted methacrylate.
Further, the photocurable non-silicon monomer (C) is one or more of tricyclopentenyl methacrylate, 3,3,5-trimethylcyclohexyl methacrylate, tetrahydrofuran methacrylate, 2-phenoxyethyl methacrylate, benzyl methacrylate, isobornyl acrylate, and cyclohexyl methacrylate.
Further, the photoinitiator (D) includes one or more of a benzoin photoinitiator, an alkyl phenyl ketone photoinitiator, acyl phosphorus oxide photoinitiator, and an anthrone photoinitiator.
Furthermore, in order to improve the performance of a composition packaging film, the composition may include

0-2 parts of an auxiliary agent. Preferably, the auxiliary agent is selected from one or more of a polymerization inhibitor, a surfactant, an antioxidant, a heat stabilizer, a defoaming agent, and a leveling agent.

The present disclosure further provides a photocurable ink composition. The photocurable ink composition includes, by weight percentage, 5-50 wt% of a photocurable monofunctional silicon-containing monomer A, 5-30 wt% of a photocurable bifunctional silicon-containing monomer B, 10-60 wt% of a photocurable non-silicon monomer C, and 0.1-10 wt% of a photoinitiator D. The ink composition constituted according to the above raw materials and weight percentages can show a high curing rate (which may reach 97%-99%), excellent flexibility, and better plasma etching performance, and is low in curing shrinkage force after curing, thereby achieving a layer without producing any displacement, such that the ink composition can be used for packaging application.

In another aspect, the present disclosure further provides a method for preparing the photocurable ink composition, and steps include: a photocurable monofunctional silicon-containing monomer (A), a photocurable bifunctional silicon-containing monomer (B), a photocurable non-silicon monomer (C), and a photoinitiator (D) are mixed, stirred, and filtered, so as to obtain the photocurable ink composition.

The photocurable ink composition prepared by using the above preparation method may have a viscosity of 8-40 cps at 25 °C, and a surface tension of 15-50 dyne/cm.

Furthermore, the present disclosure further provides an application of the photocurable ink composition in packaging of an Organic light-emitting diode thin film. Details are as follows.

The photocurable ink provided in the present disclosure is especially suitable for an ink-jet printing process, has very small surface tension and viscosity, and thus is suitable for rapid leveling, ensuring the flatness of an organic layer after film formation, thereby facilitating the deposition of an inorganic material. Moreover, the cured organic layer has excellent oxygen and water vapor barrier properties.

The photocurable ink composition provided in the present disclosure may be printed by means of ink-jet printing at a thickness of 1 μm to 15 μm, and the organic layer may be obtained through curing by irradiating with an UV light at 10 $mW/cm^2$ to 100 $mW/cm^2$ for 1 to 100 s.

The present disclosure further provides a packaging thin film, including inorganic layers and organic layers, which are sequentially alternately arranged. The organic layers may be at the top, at the bottom, or in the center, and are used as protective layers and planarization layers of a device.

More specifically, the inorganic layers in the packaging thin film are each independently selected from one or several of silicon oxide, aluminum oxide, zirconium oxide, titanium oxide, zinc oxide, silicon nitride, silicon carbide, and silicon oxynitride.

Compared with the related art, the technical solutions provided in the present disclosure have the following beneficial effects. In the present disclosure, the photocurable ink composition is printed on an inorganic layer or an Organic light-emitting diode by using the ink-jet printing process, and is cured through UV irradiation. In an aspect, the cured organic layer has appropriate elongation at break and tensile strength, that is, excellent flexibility, such that the bendability of an Organic light-emitting diode is ensured. In another aspect, in the present disclosure, through the crosslinking polymerization reaction of the particular molecular weights of the photocurable monofunctional silicon-containing monomer, photocurable bifunctional silicon-containing monomer, and photocurable non-silicon monomer, the present disclosure has a high photocuring rate and plasma etching resistance, and at the same time, the number of free small molecules is reduced, thereby reducing the emission of impurity gases. Furthermore, the photocurable ink composition prepared in the present disclosure has excellent stability before and after curing, and thus may be stored for a long time.

## Detailed Description of the Embodiments

Exemplary embodiments are described in detail here. The implementations described in the following exemplary embodiments do not represent all implementations consistent with the present disclosure. On the contrary, the implementations are merely examples of compositions, preparation methods and applications consistent with some aspects of the present disclosure as detailed in the appended claims.

In order to make those skilled in the art better understand the technical solutions of the present disclosure, the present disclosure is further described in detail below with reference to the embodiments.

Preparation embodiment 1

This preparation embodiment provided a detailed process of preparing a photocurable monofunctional silicon-containing monomer A1. A structural formula of the A1 was shown in Formula (1-1) below.

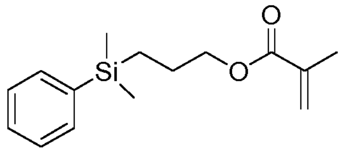

Formula (1-1)

500 mL of ethyl acetate, 34 g of dimethylphenylsilane, and 80 g of allyl alcohol were added to a reactor, and then are displaced for three times by using nitrogen; 144 ppm of a platinum-carbon black catalyst was added to the reactor; the reactor was heated to 80 °C and stirred for 4 h; the remaining solvent was removed through distillation, so as to obtain a compound 1; then 48 g of the obtained compound 1 and 32 g of triethylamine were added to 500 mL of dichloromethane; the mixture was cooled to 0 °C; 30 g of methacryloyl chloride was slowly added; the reaction was performed for 6 h after addition was completed; distillation was performed to remove the solvent; and the compound shown in Formula (1-1) might be obtained through column chromatography separation, with a yield of 75%.

Preparation embodiment 2

This preparation embodiment provided a detailed process of preparing a photocurable monofunctional silicon-containing monomer A2. A structural formula of the A2 was shown in Formula (1-2) below.

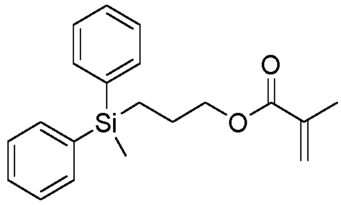

Formula (1-2)

500 mL of ethyl acetate, 50 g of diphenylmethylsilane, and 80 g of allyl alcohol were added to a reactor, and then are displaced for three times by using nitrogen; 144 ppm of a platinum-carbon black catalyst was added to the reactor; the reactor was heated to 80 °C and stirred for 4 h; the remaining solvent was removed through distillation, so as to obtain a compound 1; then 130 g of the obtained compound 1 and 32 g of triethylamine were added to 500 mL of dichloromethane; the mixture was cooled to 0 °C; 30 g of methacryloyl chloride was slowly added; and distillation was performed to remove the solvent, so as to obtain the compound shown in Formula (1-2), with a yield of 82%.

Preparation embodiment 3

This preparation embodiment provides a detailed process of preparing a photocurable monofunctional silicon-containing monomer A3. A structural formula of the A3 was shown in Formula (1-3) below.

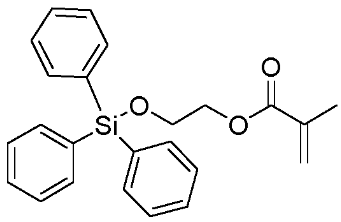

Formula (1-3)

600 mL of dichloromethane, 114.4 g of 2-hydroxyethyl methacrylate, and 100 g of triethylamine were added to a reactor; then 100 g of triphenylsilyl chloride was added to the reactor; the reactor was cooled, stirred for 1 h at 0 °C, heated to 25 °C, and stirred for 5 h at 25 °C; rotary evaporation was performed to remove the solvent; and purification was performed to obtain the compound shown in Formula (1-3), with a yield of 80%.

Preparation embodiment 4

This preparation embodiment provided a detailed process of preparing a photocurable bifunctional silicon-containing monomer B. A structural formula of the B was shown in Formula (2-1) below.

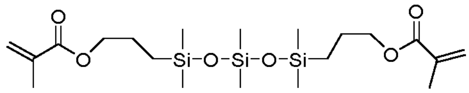

Formula (2-1)

300 mL of ethyl acetate, 18 g of 1,1,3,3,5,5-hexamethyltrisiloxane, and 40 g of allyl alcohol were placed in a 1000 mL flask provided with a cooling tube and a stirrer, and then the flask was purged for 30 min with nitrogen. Then, 72 ppm of a Karstedt catalyst was added; then the flask was heated to 80 °C, and components were stirred for 4 h; and the remaining solvent was removed through dilution, so as to obtain the compound shown in the Formula (2-1). 68.4 g of the obtained compound and 37 g of triethylamine were sequentially added to 300 mL of dichloromethane; then while the mixture was slowly stirred at 0 °C, 29.1 g of methacryloyl chloride was slowly added, and a temperature was controlled at 0±2 °C; and the remaining solvent was removed through distillation, so as to obtain the compound shown in the Formula (2-1).

The components used in the embodiments and comparative embodiments in a test process below were shown in detail as follows.

(A) Photocurable monofunctional silicon-containing monomer: A1, with a molecular weight of 262.42, that is, the Formula (1-1) in Preparation embodiment 1; A2, with a molecular weight of 324.5, that is, the Formula (1-2) in Preparation embodiment 2; and A3, with a molecular weight of 388.54, that is, the Formula (1-3) in Preparation embodiment 3.

(B) Photocurable bifunctional silicon-containing monomer: B1, the Formula (2-1) in Preparation embodiment 4.

(C) Photocurable non-silicon monomer: C1, tetrahydrofurfuryl acrylate (TCI AMERICA), C2, isobornyl acrylate (TCI AMERICA).

(D) Photoinitiator: Photoinitiator TPO (Sigma-Aldrich).

Embodiment 1

Embodiment 1 provided a photocurable ink composition (I), which was composed of the following components: by weight percentage, 45% of a photocurable monofunctional silicon-containing monomer A, 20% of a photocurable bifunctional silicon-containing monomer B, 30% of a photocurable non-silicon monomer C, and 5% of a photoinitiator D.

(A) The photocurable monofunctional silicon-containing monomer was A1, that is, the Formula (1-1) in Preparation embodiment 1, with a molecular weight of 262.42.

(B) The photocurable bifunctional silicon-containing monomer was the Formula (2-1) in Preparation embodiment 4.

(C) The photocurable non-silicon monomer was C1, that is, tetrahydrofurfuryl acrylate.

(D) The photoinitiator was a photoinitiator TPO.

Embodiment 1 further provided a method for preparing the photocurable ink composition (I), and steps included: the photocurable monofunctional silicon-containing monomer, the photocurable bifunctional silicon-containing monomer, the photocurable non-silicon monomer, and the photoinitiator were mixed, stirred, and filtered, so as to obtain the photocurable ink composition (I).

Embodiment 2

Embodiment 2 provided a photocurable ink composition (II), which was composed of the following components: by weight percentage, 30% of a photocurable monofunctional silicon-containing monomer A, 30% of a photocurable bifunctional silicon-containing monomer B, 35% of a photocurable non-silicon monomer C, and 5% of a photoinitiator D.

(A) The photocurable monofunctional silicon-containing monomer was A2, that is, the Formula (1-2) in Preparation embodiment 2, with a molecular weight of 324.5.

(B) The photocurable bifunctional silicon-containing monomer was the Formula (2-1) in Preparation embodiment 4.

(C) The photocurable non-silicon monomer was C1, that is, tetrahydrofurfuryl acrylate.

(D) The photoinitiator was a photoinitiator TPO.

Embodiment 2 further provided a method for preparing the photocurable ink composition (II), and steps included: the photocurable monofunctional silicon-containing monomer, the photocurable bifunctional silicon-containing monomer, the photocurable non-silicon monomer, and the photoinitiator were mixed, stirred, and filtered, so as to obtain the photocurable ink composition (II).

Embodiment 3

Embodiment 3 provided a photocurable ink composition (III), which was composed of the following components: by weight percentage, 30% of a photocurable monofunctional silicon-containing monomer A, 30% of a photocurable bifunctional silicon-containing monomer B, 35% of a photocurable non-silicon monomer C, and 5% of a photoinitiator D.

(A) The photocurable monofunctional silicon-containing monomer was A1, that is, the Formula (1-1) in Preparation embodiment 1, with a molecular weight of 262.42.

(B) The photocurable bifunctional silicon-containing monomer was the Formula (2-1) in Preparation embodiment 4.

(C) The photocurable non-silicon monomer was C2, that is, isobornyl acrylate.

(D) The photoinitiator was a photoinitiator TPO.

Embodiment 3 further provided a method for preparing the photocurable ink composition (III), and steps included: the photocurable monofunctional silicon-containing monomer, the photocurable bifunctional silicon-containing monomer, the photocurable non-silicon monomer, and the photoinitiator were mixed, stirred, and filtered, so as to obtain the photocurable ink composition (III).

Embodiment 4

Embodiment 4 provided a photocurable ink composition (IV), which was composed of the following components: by weight percentage, 40% of a photocurable monofunctional silicon-containing monomer A, 35% of a photocurable bifunctional silicon-containing monomer B, 20% of a photocurable non-silicon monomer C, and 5% of a photoinitiator D.

(A) The photocurable monofunctional silicon-containing monomer was a mixture of the A1 and A2, with a mass ratio of 1:1.

(B) The photocurable bifunctional silicon-containing monomer was the Formula (2-1) in Preparation embodiment 4.

(C) The photocurable non-silicon monomer was C2, that is, isobornyl acrylate.

(D) The photoinitiator was a photoinitiator TPO.

Embodiment 4 further provided a method for preparing the photocurable ink composition (IV), and steps included: the photocurable monofunctional silicon-containing monomer, the photocurable bifunctional silicon-containing monomer, the photocurable non-silicon monomer, and the photoinitiator were mixed, stirred, and filtered, so as to obtain the photocurable ink composition (IV).

Comparative embodiment 1

Compared with Embodiment 1, a difference between a specific implementation of Comparative embodiment 1 and Embodiment 1 lied in that, the photocurable monofunctional silicon-containing monomer A was not added to the photocurable ink composition in Comparative embodiment 1. The photocurable ink composition (V) in Comparative embodiment 1 was composed of the following components: by weight percentage, 40% of a photocurable bifunctional silicon-containing monomer B, 55% of a photocurable non-silicon monomer C, and 5% of a photoinitiator D.

The photocurable ink composition in Comparative embodiment 1 might be obtained through preparation in the same manner as in Embodiment 1.

Comparative embodiment 2

Compared with Embodiment 1, a difference between a specific implementation of Comparative embodiment 2 and Embodiment 1 lied in that, the photocurable bifunctional silicon-containing monomer B was not added to the photocurable ink composition in Comparative embodiment 2; and the photocurable ink composition (VI) in Comparative embodiment 2 was composed of the following components: by weight percentage, 50% of a photocurable monofunctional silicon-containing monomer A, 45% of a photocurable non-silicon monomer C, and 5% of a photoinitiator D.

The photocurable ink composition in Comparative embodiment 2 might be obtained through preparation in the same manner as in Embodiment 1.

Comparative embodiment 3

Compared with Embodiment 1, a difference between a specific implementation of Comparative embodiment 3 and Embodiment 1 lied in that, the photocurable monofunctional silicon-containing monomer in Comparative embodiment 3 was A3, that is, the Formula (1-3) in Preparation embodiment 3, with a molecular weight of 388.54.

The photocurable ink composition (VII) in Comparative embodiment 3 might be obtained through preparation in the same manner as in Embodiment 1.

Comparative embodiment 4

Compared with Embodiment 1, a difference between a specific implementation of Comparative embodiment 4 and Embodiment 1 lied in that, the photocurable non-silicon monomer C was not added to the photocurable ink composition in Comparative embodiment 4; and the photocurable ink composition (VIII) in Comparative embodiment 4 was composed of the following components: by weight percentage, 50% of a photocurable monofunctional silicon-containing monomer A, 45% of a photocurable bifunctional silicon-containing monomer B, and 5% of a photoinitiator D.

The photocurable ink composition (VIII) in Comparative embodiment 4 might be obtained through preparation in the same manner as in Embodiment 1.

The photocurable ink compositions obtained in the above Embodiments 1-4 and Comparative embodiments 1-4 were subjected to the following performance tests.

1. Photocuring rate: the photocurable ink composition was coated on an ITO glass substrate, and was subjected to UV curing for 60 s through UV irradiation at 30 $mW/cm^2$, so as to prepare a sample with a dimension of 3 cm × 7.5 cm × 18 μm (width × length × thickness); and then FT-IR (NicoletiS50, Thermo-Fisher) was used to measure absorption peak intensities of the ink before curing and an organic thin film after curing near 1635 $cm^{-1}$(C=C) and 1720 $cm^{-1}$(C=O).

$$\text{Photocuring rate (\%)} = |1-(F/S)| \times 100$$

F was a ratio of the absorption peak intensity of the organic thin film after curing near 1635 $cm^{-1}$ to the absorption peak intensity near 1720 $cm^{-1}$; and S was a ratio of the absorption peak intensity of the uncured ink near 1635 $cm^{-1}$ to the absorption peak intensity near 1720 $cm^{-1}$.

2. Elongation at break: the photocurable ink composition was coated on the ITO glass substrate, and was subjected to UV curing for 60 s through UV irradiation at 30 $mW/cm^2$, so as to obtain a sample, and determination was performed according to the GB/T1040.1-2006 plastic tensile property.

3. Tensile strength: the photocurable ink composition was coated on the ITO glass substrate, and was subjected to UV curing for 60 s through UV irradiation at 30 $mW/cm^2$, so as to obtain a sample, and determination was performed according to the GB/T1040-92 General Test Method for Mechanical Properties of Plastics (Tensile). Instrument: WDW-5A microcomputer controlled electronic universal testing machine; and test conditions: a tensile speed was 1 mm/min, each group had at least 5 samples, and the test results were averaged.

4. Outgas measurement: the photocurable ink compositions obtained in Embodiments 1-4 and Comparative embodiments 1-4 were coated on 10 cm × 10 cm glass to obtain coatings with a thickness of 5 μm, and were subjected to UV curing for 60 s through UV irradiation at 30 $mW/cm^2$ in a nitrogen atmosphere, so as to obtain cured organic layers; then the organic layers were cut into samples with a dimension of 1 cm × 3 cm; and a JAI thermal desorption apparatus (JTD-505III) was used, and Outgases were collected for 30 min at 120 °C, respectively. After the sampled were determined by using a gas chromatography mass spectrometer (QP2020GC/MS), a calibration curve was drawn, and the collected sample Outgases were analyzed.

The above performance test results of the photocurable ink compositions obtained in Embodiments 1-4 and Comparative embodiments 1-4 were shown in Table 1.

Table 1

| Embodiment/comparative embodiment | Photocuring rate/% | Elongation at break/% | Tensile strength (MPa) | Outgas (ppm) |
|---|---|---|---|---|
| Embodiment 1 | 98.6 | 10.32 | 26.12 | 3.91 |
| Embodiment 2 | 98.2 | 10.52 | 25.82 | 4.12 |
| Embodiment 3 | 98.3 | 11.31 | 25.41 | 4.23 |
| Embodiment 4 | 97.9 | 10.56 | 26.41 | 4.06 |
| Comparative embodiment 1 | 94.1 | 4.21 | 15.12 | 6.21 |
| Comparative embodiment 2 | 96.8 | 16.12 | 20.15 | 5.12 |
| Comparative embodiment 3 | 92.4 | 18.15 | 18.58 | 7.16 |
| Comparative embodiment 4 | 95.6 | 17.26 | 19.45 | 5.95 |

From the test results in Table 1, it might be learned that, the photocurable ink composition prepared in the present disclosure could achieve a high photocuring rate, excellent flexibility (appropriate elongation at break and tensile strength), and a lower Outgas value, and the emission of impurity gases after film formation of the organic layer was reduced, such that the Organic light-emitting diode had higher stability.

Rather, in combination with Table 1, a photocurable ink composition prepared by any one of the photocurable monofunctional silicon-containing monomer A, the photocurable bifunctional silicon-containing monomer B, and the photocurable non-silicon monomer C could not reach an ideal effect in terms of photocuring rate, elongation at break, tensile strength, and Outgas. Furthermore, the photocurable monofunctional silicon-containing monomer with a molecular weight greater than 350 was used in Comparative embodiment 3, the photocuring rate of the prepared photocurable ink composition was only 92.4%, which was far less than that in Embodiments 1-4, and at the same time, and the Outgas value was far greater than that in Embodiments 1-4, causing the elongation at break of the cured thin film of the photocurable ink composition to be too large and the tensile strength to be too small, thus resulting in poor mechanical property, such that it was difficult to effectively package the Organic light-emitting diode.

The above is merely the implementation of the present disclosure, to make those skilled in the art to understand or implement the present disclosure. It is apparent that those skilled in the art will make many modifications to these embodiments, the general principles defined in the disclosure may be achieved in the other embodiments without departing from the spirit or scope of the present disclosure.

It should be understood that, the present disclosure is not limited to the above content that has been described, and various modifications and changes can be made without departing from the scope of the present disclosure. The scope of the present disclosure is merely limited by the appended claims.

## Claims

**1.** A photocurable ink composition, comprising a photocurable monofunctional silicon-containing monomer (A), a photocurable bifunctional silicon-containing monomer (B), a photocurable non-silicon monomer (C), and a photoinitiator (D), wherein

a structural formula of the photocurable monofunctional silicon-containing monomer (A) is shown in a Formula (1) below:

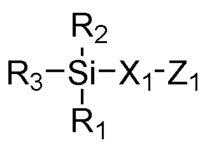

Formula (1)

in the Formula (1), $R_1$, $R_2$, and $R_3$ are each independently any one of alkyl, alkoxy, phenyl;
$X_1$ is a single bond, O, S, NH, or NR', wherein R' is any one of substituted or unsubstituted C1-C10 alkyl,

substituted or unsubstituted C3-C10 cycloalkyl, and substituted or unsubstituted C1-C10 aryl;
$Z_1$ is a group shown in a Formula 2 or a Formula 3;

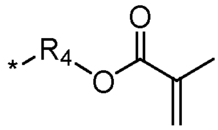
Formula (2)

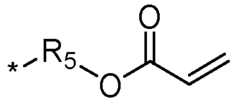
Formula (3)

in the Formulas (2) to (3), * is a binding site of $X_1$ in the Formula (1); and $R_4$ and $R_5$ are each independently any one of substituted or unsubstituted C1-C20 alkylene, and a substituted or unsubstituted C1-C20 alkylene ether group.

2. The photocurable ink composition according to claim 1, wherein the photocurable bifunctional silicon-containing monomer (B) is shown in a Formula (4):

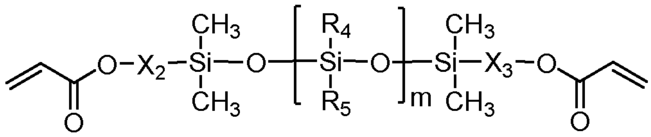
Formula (4)

in the Formula (4), $R_4$ and $R_5$ are each independently any of alkyl and alkoxy; and $X_2$ and $X_3$ are each independently any of a single bond, alkylene, and an alkylene oxygen group.

3. The photocurable ink composition according to claim 1, wherein a molecular weight of the photocurable monofunctional silicon-containing monomer (A) is 250-350.

4. The photocurable ink composition according to claim 1, wherein the photocurable non-silicon monomer (C) comprises a fat ring or benzene-substituted methacrylate.

5. The photocurable ink composition according to claim 1, wherein the photoinitiator (D) comprises one or more of a benzoin photoinitiator, an alkyl phenyl ketone photoinitiator, acyl phosphorus oxide photoinitiator, and an anthrone photoinitiator.

6. The photocurable ink composition according to claim 1, wherein by weight percent, a proportion of each raw material is as follows: 5-50 wt% of the photocurable monofunctional silicon-containing monomer (A), 5-30 wt% of the photocurable bifunctional silicon-containing monomer (B), 10-60 wt% of the photocurable non-silicon monomer (C), and 0.1-10 wt% of the photoinitiator (D).

7. The photocurable ink composition according to claim 5, further comprising 0-2 wt% of an auxiliary agent.

8. The photocurable ink composition according to claim 1, wherein the viscosity of the photocurable ink at 25 °C is 15-40 cps, and surface tension is 15-50 dyne/cm.

9. A method for preparing the photocurable ink composition according to any one of claims 1 to 8, wherein specific steps are as follows: mixing, stirring, and filtering a photocurable monofunctional silicon-containing monomer (A), a photocurable bifunctional silicon-containing monomer (B), a photocurable non-silicon monomer (C), and a photoinitiator (D), so as to obtain the photocurable ink composition.

10. An application of the photocurable ink composition according to any one of claims 1 to 8 in packaging of an Organic Light-Emitting Diode thin film.

**INTERNATIONAL SEARCH REPORT**

International application No. **PCT/CN2023/136527**

**A. CLASSIFICATION OF SUBJECT MATTER**

C09D11/30(2014.01)i; C08F230/08(2006.01)i; C09D11/101(2014.01)i; C07F7/18(2006.01)i; C09D11/38(2014.01)i

According to International Patent Classification (IPC) or to both national classification and IPC

**B. FIELDS SEARCHED**

Minimum documentation searched (classification system followed by classification symbols)

C09D C08F

Documentation searched other than minimum documentation to the extent that such documents are included in the fields searched

Electronic data base consulted during the international search (name of data base and, where practicable, search terms used)

CNTXT, DWPI, CNKI, USTXT, EPTXT, WOTXT: 西安思摩威新材料有限公司, 何鑫, 王娜, 陈厚银, 硅, 油墨, 光固化, 光引发, 紫外, 单官, 双官, 二官, silicon, ink, photoinitiator, UV, monofunctional, difunctional

**C. DOCUMENTS CONSIDERED TO BE RELEVANT**

| Category* | Citation of document, with indication, where appropriate, of the relevant passages | Relevant to claim No. |
|---|---|---|
| X | CN 108137755 A (SAMSUNG SDI CO., LTD.) 08 June 2018 (2018-06-08)<br>description, paragraphs 21, 120-131, 141, 143, and 160-190, and embodiment 1 | 1-10 |
| X | CN 114031972 A (XI'AN SIMOWEI NEW MATERIAL CO., LTD.) 11 February 2022 (2022-02-11)<br>claims 1-10 | 1-10 |
| A | CN 115216178 A (XI'AN SIMOWEI NEW MATERIAL CO., LTD.) 21 October 2022 (2022-10-21)<br>entire document | 1-10 |
| A | CN 115260226 A (XI'AN SIMOWEI NEW MATERIAL CO., LTD.) 01 November 2022 (2022-11-01)<br>claims 1-10, and embodiment 1 | 1-10 |
| A | US 2019031902 A1 (CANON K. K.) 31 January 2019 (2019-01-31)<br>entire document | 1-10 |
| PX | CN 115960490 A (XI'AN SIMOWEI NEW MATERIAL CO., LTD.) 14 April 2023 (2023-04-14)<br>description, paragraphs 6-92 | 1-10 |

☑ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **23 January 2024** | **01 February 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | Telephone No. |

Form PCT/ISA/210 (second sheet) (July 2022)

**INTERNATIONAL SEARCH REPORT**

International application No.
**PCT/CN2023/136527**

**C. DOCUMENTS CONSIDERED TO BE RELEVANT**

| Category* | Citation of document, with indication, where appropriate, of the relevant passages | Relevant to claim No. |
|---|---|---|
| A | US 2020270472 A1 (SEIKO EPSON CORP.) 27 August 2020 (2020-08-27) entire document | 1-10 |

Form PCT/ISA/210 (second sheet) (July 2022)

**INTERNATIONAL SEARCH REPORT**
**Information on patent family members**

International application No.
**PCT/CN2023/136527**

| Patent document cited in search report | | | Publication date (day/month/year) | Patent family member(s) | | | Publication date (day/month/year) |
|---|---|---|---|---|---|---|---|
| CN | 108137755 | A | 08 June 2018 | KR | 20170045792 | A | 28 April 2017 |
| | | | | KR | 101835941 | B1 | 08 March 2018 |
| | | | | US | 2023203225 | A1 | 29 June 2023 |
| | | | | WO | 2017069392 | A2 | 27 April 2017 |
| | | | | JP | 2018533644 | A | 15 November 2018 |
| | | | | JP | 6755309 | B2 | 16 September 2020 |
| | | | | US | 2018342674 | A1 | 29 November 2018 |
| | | | | US | 11608400 | B2 | 21 March 2023 |
| CN | 114031972 | A | 11 February 2022 | | None | | |
| CN | 115216178 | A | 21 October 2022 | | None | | |
| CN | 115260226 | A | 01 November 2022 | | None | | |
| US | 2019031902 | A1 | 31 January 2019 | EP | 3438210 | A1 | 06 February 2019 |
| | | | | JP | 2017186520 | A | 12 October 2017 |
| | | | | JP | 6968541 | B2 | 17 November 2021 |
| | | | | US | 10850531 | B2 | 01 December 2020 |
| CN | 115960490 | A | 14 April 2023 | | None | | |
| US | 2020270472 | A1 | 27 August 2020 | JP | 2020139023 | A | 03 September 2020 |
| | | | | JP | 7265222 | B2 | 26 April 2023 |
| | | | | US | 11142663 | B2 | 12 October 2021 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 202211574896
- CN 106257681 B
- CN 113717350 A